# EUROPEAN PATENT APPLICATION

(11) **EP 4 711 847 A1**
(43) Date of publication of application: **18.03.2026**
(21) Application number: 25187888.0
(22) Date of filing: 07.07.2025
(51) Int. Cl.: G03F 1/24, G03F 1/48

(54) **A PROCESS AND AN APPARATUS FOR THE PASSIVATION OF THE BLACK BORDER SIDEWALL ON THE EXTREME ULTRAVIOLET PHOTOMASKS**

(30) Priority: 10.09.2024 US 202418829347
(71) Applicant: Intel Corporation, Santa Clara, CA 95054 (US)
(72) Inventor: KIM, Yongbae, San Jose 95125 (US)
(74) Representative: Viering, Jentschura & Partner mbB Patent- und Rechtsanwälte

(57) **Abstract**

The present disclosure generally relates to a method that includes providing a photomask, wherein the photomask includes a trench defined by two sidewalls which are exposed, introducing the photomask into a controlled environment, and directing (i) one or more reactive gases, (ii) a laser, (iii) one or more reactive gases and a laser, or (iv) one or more reactive gases and an electron beam, to the two sidewalls to render a passivation layer adjacent to and in contact with each sidewall. An apparatus and the photomask are also described.

## Description

### BACKGROUND

Lithography (e.g., photolithography) may be a process in semiconductor and circuit fabrications. Lithography, such as photolithography, may involve a photomask, which may be used to form patterned layers during fabrication. A photomask, such as an extreme ultraviolet (EUV) photomask, may include a black border, which may help reduce unwanted reflection of EUV, i.e., the black border may prevent light scattering and reflections that interfere with imaging performance, for example, at the edge of the exposure in-die field. In etched black border (BB) technology, the BB area may be defined, for example, by removing a portion of the photomask. Removing a portion of the photomask may render a sidewall, referred to as "black border sidewall" in the present disclosure, which may be denoted as "BB sidewall" for brevity.

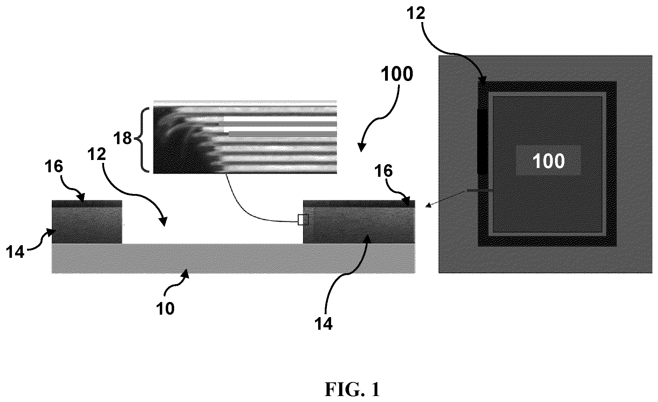

One issue with black border in photomask is that, as may be seen in FIG. 1, the BB sidewall may be chemically vulnerable during subsequent processing or wafer exposure using the photomask inside a scanner unless the BB sidewall is well passivated. This may be because the materials forming the BB sidewall, such as molybdenum (Mo) and/or silicon (Si), may be reacted away by any reactive chemical species or may diffuse out during EUV exposure inside the scanner. FIG. 1 shows an example of a BB sidewall (denoted "18") that was not properly passivated and sustained damage during manufacturing.

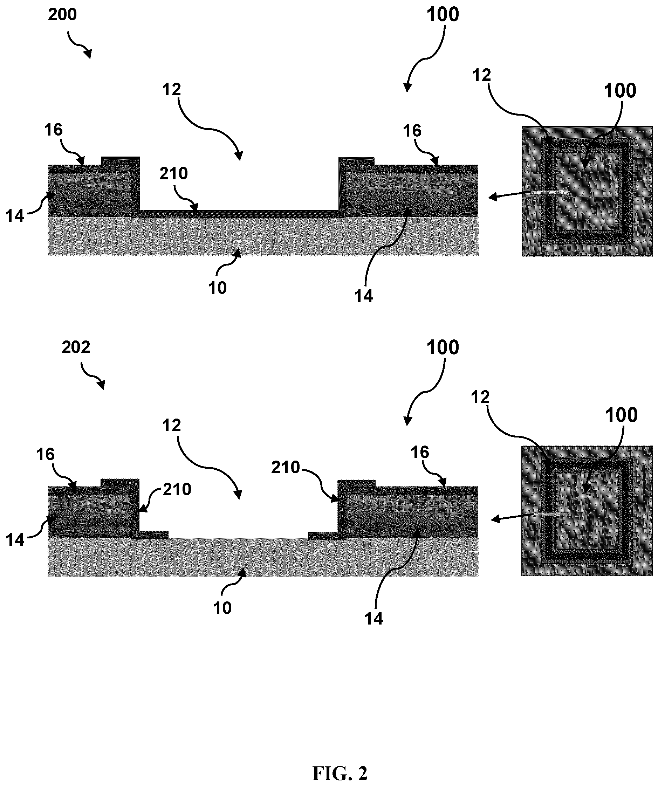

FIG. 2 shows examples of two possible passivation strategies (top and bottom images). However, such passivation strategies tend to at least require additional patterning processes that may be traditional, such as including at least a film deposition step, a lithographic step, an etching step, and wet or dry strip step, which are time consuming and uneconomical. Also, such traditional techniques may degrade EUV and/or deep ultraviolet (DUV) reflectivity on the BB area and on the patterns on the in-die area. Because of such additional patterning process, the critical dimension (CD) performance of the in-die area may suffer from degradation too.

In addition, traditional EUV lithography may suffer from poor BB pattern fidelity, for example, due to sidewall damage on the photomask. This in turn may render poor wafer printing performance during printing in a scanner, and CD uniformity may be adversely affected.

### BRIEF DESCRIPTION OF THE DRAWINGS

In the drawings, like reference characters generally refer to the same parts throughout the different views. The drawings are not necessarily to scale, emphasis instead generally being placed upon illustrating the principles of the present disclosure. The dimensions of the various features or elements may be arbitrarily expanded or reduced for clarity. In the following description, various aspects of the present disclosure are described with reference to the following drawings, in which:
FIG. 1 shows an example of the plan view of a photomask (right image), and an example of the cross-section view of the black border with a high-resolution transmission electron microscopy (HR-TEM) image of a multi-layer sidewall of the black border;
FIG. 2 shows two examples of passivation strategies traditionally derived with additional processes;
FIG. 3 illustrates for a method and a nozzle of an apparatus described in aspects of the present disclosure;
FIG. 4 shows the nozzle traversing along the black border (top image), the shape and Gaussian energy distribution of a laser beam (center image), and the vertical projection of the laser beam to the sidewall (bottom image) as an example, described in aspects of the present disclosure;
FIG. 5 shows the projection of a laser beam to the sidewall similar to the bottom image of FIG. 4 except in this instance the laser beam is projected at an angle with respect to the sidewall described in aspects of the present disclosure; and
FIG. 6 is a general schematic showing a non-limiting example of the apparatus described in aspects of the present disclosure.

### DETAILED DESCRIPTION

The following detailed description refers to the accompanying drawings that show, by way of illustration, specific details and aspects in which the present disclosure may be practiced. These aspects are described in sufficient detail to enable those skilled in the art to practice the present disclosure. Various aspects are provided for apparatuses, and various aspects are provided for methods. It will be understood that the basic properties of the apparatuses also hold for the methods and vice versa. Other aspects may be utilized and structural, and logical changes may be made without departing from the scope of the present disclosure. The various aspects are not necessarily mutually exclusive, as some aspects may be combined with one or more other aspects to form new aspects.

The present disclosure generally relates to a method. The method may help to address any of the issues and limitations mentioned above. For instance, the method may help to address any of the issues and limitations associated with the black border of a photomask in lithography processes.

Lithography, e.g., photolithography, is a semiconductor fabrication process that involves a photomask. An area or a portion of the photomask may be etched, which may form a channel in the photomask. This channel (i.e., the area or portion etched), in the context of the present disclosure, may be referred to as a black border or for brevity a "trench". The black border may have two sidewalls, defining the channel, wherein the sidewalls may be exposed. At the channel, the sidewalls may be exposed, for example, after etching. The sidewalls may be vulnerable, for example, to being reacted away by a chemical, especially so in subsequent photomask processing. The sidewalls may be vulnerable, for example, to material loss by diffusion of photomask materials out of and away from the sidewalls. The sidewalls defining the channel (i.e., "black border sidewalls") may then become anisotropic. For example, the sidewalls may become slanted or concave inward away from the trench. A photomask with a sidewall facing such issues and/or limitations, in turn may suffer from dimensional inaccuracy, overlay alignment issues, poor process uniformity, and/or poor pattern fidelity. Poor pattern fidelity may include pattern distortion, non-uniform sizes, line bridging or pinching, and rough surfaces.

In addition, as mentioned above, traditional extreme ultraviolet (EUV) lithography may suffer from poor black border pattern fidelity. Desirable black border pattern fidelity without sidewall damage on a photomask renders good wafer printing performance during the wafer print in the scanner. If the black border pattern fidelity is not good, then the advantages and/or purpose(s) of the black border may not be accomplished reliably. The black border helps to improve the critical dimension (CD) uniformity of a wafer on which reflected light (EUV or DUV) from the photomask is exposed by minimizing unwanted deep ultraviolet light or extreme ultraviolet light reflected near the black border area on the photomask.

To deal with one or more of the issues and limitations mentioned above, traditional passivation techniques were developed. However, such traditional passivation techniques tend to require additional processing steps, such as deposition of additional materials at the side wall, patterning the additional materials, and etching the additional materials, etc., which tend to be time consuming, more energy intensive, and uneconomical.

The method described in aspects of the present disclosure may help to address and/or circumvent any of the issues and limitations.

The present disclosure also describes an apparatus and a photomask, which may help to address and/or circumvent any of the issues and limitations mentioned above. The apparatus may be operable to carry out the method, and the photomask may be passivated with the method (i.e., a passivated photomask may be generated via the method). To more readily understand and put into practical effect the present disclosure, particular aspects will now be described by way of examples and not limitations, and with reference to the drawings. For the sake of brevity, duplicate descriptions of features and properties may be omitted.

FIG. 1 identifies sidewall. FIG. 1 shows a plan view of a photomask on a substrate, including the black border 12 (abbreviated as "BB" in the present disclosure) shown in the right of FIG. 1, and a cross-section view of the black border 12 is shown on the left of FIG. 1. FIG. 1 also shows a HR-TEM image of the sidewall composed of multi-layered materials 18 (e.g., silicon and/or molybdenum). The black border 12 may be adjacent to the in-die area 100. In the left image, it can be seen that the photomask may include a substrate 10, a patterned film 14 (referred as "film" in the present disclosure for brevity) that includes a trench (i.e., the black border 12), and an absorber 16. From FIG. 1, it can be understood that unless the sidewall is well passivated, the sidewall may be chemically vulnerable during subsequent photomask processing or wafer exposure using the photomask. This may be because the multi-layered materials 18, such as silicon and/or molybdenum, may react with reactive chemicals or diffuse out, for example, during extreme ultraviolet light (or deep ultraviolet light) exposure inside a scanner. The HR-TEM image in FIG. 1 shows an example of the multi-layered materials 18 of a sidewall that was not passivated and sustained damage during photomask manufacturing.

FIG. 2 shows two examples of possible passivation layer 210 formed from traditional passivation techniques 200, 202. In technique 200, a passivation layer 210 is formed over the sidewall and the entire black border 12, wherein the passivation layer 210 extends beyond the height of each sidewall and horizontally overlays on the absorber 16. In technique 202, a passivation layer 210 is formed on the side wall but not covering the entire black border 12. However, such techniques require additional patterning steps, including at least a film deposition step, a lithographic step, an etching step, and wet or dry strip step, rendering such techniques time consuming, more energy intensive, and uneconomical. Also, such techniques may degrade the EUV or DUV reflectivity on the black border 12 and on the patterns at the in-die area 100. Because of such additional steps, there may be a higher chance of the critical dimension (CD) and performance of the in-die at the in-die area 100 degraded.

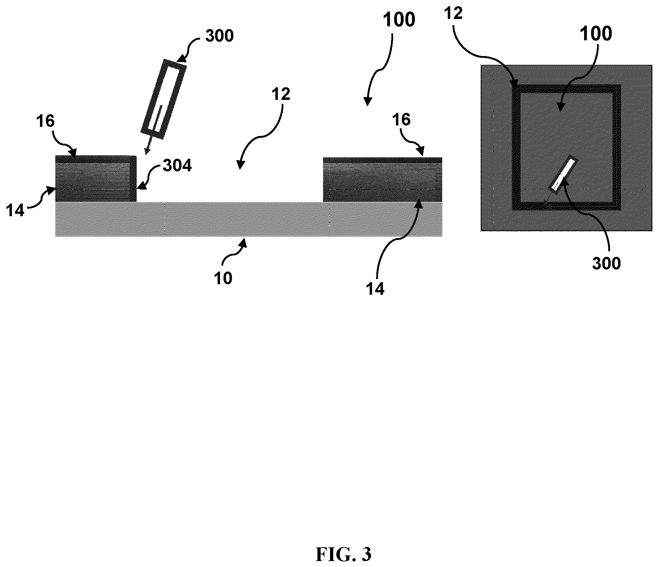

FIG. 3 shows details of the method and the apparatus, which are described further in the example section below. The multi-layered sidewalls may be passivated using one or more nozzles 300 that locally emit (i) one or more reactive gases, or (ii) a laser, or (iii) one or more reactive gases and a laser, or (iv) one or more reactive gases and an electron beam, toward a sidewall of the black border 12 (see left image) and along the black border 12 (see right image). After one sidewall is passivated (passivation layer 304 formed), the one or more nozzles may be rotatably positioned to direct (i) the one or more reactive gases, or (ii) the laser, or (iii) the one or more reactive gases and the laser, or (iv) the one or more reactive gases and the electron beam, toward the other sidewall. At a sidewall, a passivation process confined to the sidewall may occur (i.e., localized passivation process). The localized passivation process may include plasma oxidation, plasma nitridation, focus electron beam deposition, or surface quenching, depending on what was emitted from the one or more nozzles 300. The localized passivation process is confined to the multi-layered sidewall of the black border 12. For passivation, as mentioned above, one or multiple nozzles 300 may direct (or dispense or project) one or more reactive species, such as a reactive gas, an electron beam, or a laser (or light) toward or at the sidewall, which may help passivate the multi-layered sidewall, in turn preventing the multi-layered materials of the sidewalls from diffusing out. The localized passivation process may include oxidation (e.g., oxygen may be used), nitridation (e.g., nitrogen, or a mixture of hydrogen and nitrogen, may be used), deposition, and/or surface quenching (e.g., laser or electron beam may be used), depending on what was emitted by the one or more nozzles 300. The one or more nozzles 300 may be a plasma jet nozzle that ejects reactive plasma species (i.e., plasma) confined to the sidewalls, wherein the plasma may render oxidation (e.g., when oxygen is provided) or nitridation (e.g., when nitrogen or a forming gas is provided) of the exposed sidewalls' surface. The plasma may be derived from oxygen, hydrogen, nitrogen, or a mixture of any of aforesaid gases, without being limited to these gases. In various examples, the one or more nozzles 300 may project a laser or a focused electron beam that may form a metallic or a dielectric passivation layer on the sidewall that has been exposed to the laser or the electron beam in the presence of a reactive species (e.g., one or more reactive gases) dispensed from another nozzle (not shown). In various examples, the one or more nozzles 300 may project a laser, by which the exposed surface of a sidewall may be locally heated by the laser and locally quenched by the laser energy, that is to say, the laser passivates the sidewall (without involving one or more reactive gases). 100 denotes the in-die area. The substrate of the photomask is denoted 10, the patterned film of the photomask is denoted 14, and the absorber is denoted 16. The same reference numerals may be used to denote the same parts or components as described above with reference to FIG. 1 and/or FIG. 2 (unless otherwise stated), and hence shall not be reiterated for brevity.

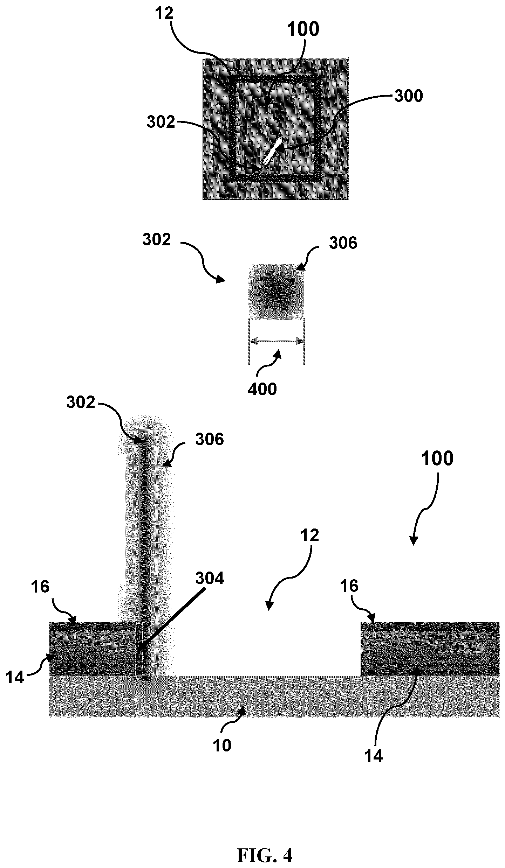

FIG. 4 shows one of the ways in which the apparatus or processes mentioned above may be implemented. FIG. 4 demonstrates passivating sidewalls of a photomask using a laser 302. The top image is a plan view showing the multi-layered sidewall of a black border 12 of a photomask passivated using a nozzle 300 that emits a laser 302. 100 denotes the in-die area. The laser beam (i.e., the laser 302) may be circular and may have a Gaussian energy distribution 306 in the range of millimeters or centimeters. The laser's size or shape 400 may be configured with the use of laser slits or laser objective lenses. As an example, a few micrometer square laser beam may be generated with commercially available lasers. One advantage of laser passivation may include that the laser process time may be precisely controlled up to picoseconds or femtoseconds without any problems using the laser wavelength within a few hundred or thousand nm range. Then, it may be possible to minimize unintentional damage on the sidewall (and even the black border 12) that is not exposed to the laser 302. There may be commercially available laser types, such as infrared laser with relatively long wavelength (more than 1000 nm) and ultraviolet light laser with relatively short wavelength (less than 400 nm) that enable the process performance for the sidewall modification. The environment (i.e., ambient) of the laser treated surface or the process chamber in which the passivation process may be carried out may have one or more reactive gases supplied or present to control the surface reaction at the sidewalls. As an example, the laser annealing process may be done in nitrogen to minimize any oxidation of the sidewalls. Another example may be the laser annealing carried out in oxygen to enhance the oxidation locally for sidewalls' passivation. The same reference numerals may be used to denote the same parts or components as described above with reference to one or more of FIG. 1 to FIG. 3 (unless otherwise stated), and hence shall not be reiterated for brevity.

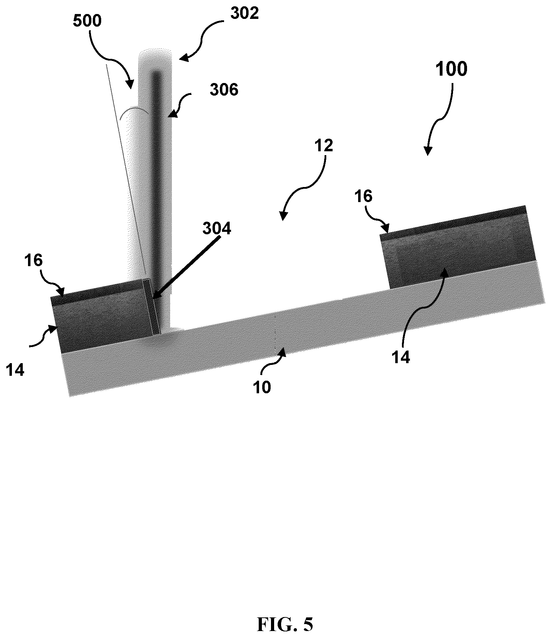

FIG. 5 shows that the laser 302 may be exposed on the photomask surface at a tilted angle 500 to expose the sidewall uniformly. By utilizing such an angle 500, the thermal energy from the laser 302 may be spread uniformly on the sidewall to form a uniform passivation layer 304 instead of the top surface of the sidewall (and the absorber 16, if present) having a higher exposure to the laser 302. The same reference numerals may be used to denote the same parts or components as described above with reference to one or more of FIG. 1 to FIG. 4 (unless otherwise stated), and hence shall not be reiterated for brevity.

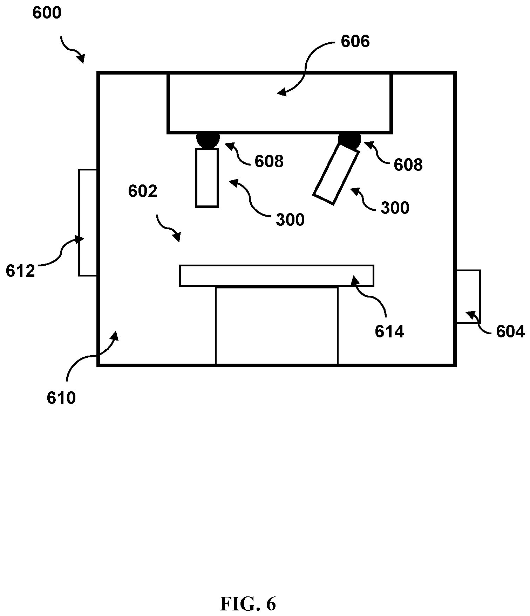

FIG. 6 is a general schematic showing an apparatus 600 of the present disclosure that is operable to carry out the method for passivation of the sidewalls. The apparatus 600 may have a chamber 610. The apparatus 600 may include at least one stage 602 configured in the chamber 610, one or more nozzles 300 (or laser guns) that may supply laser energy (or one or more reactive gases) to the black border area on the masks locally, a gas supply system (not shown), and an exhaust port 604 that exhausts heat and/or the one or more reactive gases. In various examples, the one or more nozzles 300 may be configured in the chamber 610. In various examples, the stage 602 may include a chuck 614 for a photomask to be placed thereon. The apparatus 600 may include an actuator 606 which may be operably coupled to a respective nozzle of the one or more nozzles 300. The apparatus 600 may include a joint 608 which the actuator 606 and the respective nozzle are coupled to, wherein the respective nozzle may be rotatable by the actuator 606 about the joint 608. In various examples, each of the one or more nozzles 300 may have an outlet (not shown). The one or more nozzles 300 may direct (i) one or more reactive gases, or (ii) a laser, or (iii) one or more reactive gases and a laser, or (iv) one or more reactive gases and an electron beam, to the sidewalls of a photomask (or one sidewall at a time) to render a passivation layer adjacent to and in contact with each sidewall. In various examples, the chamber 610 may include a door 612, which may be openable and closeable to allow a photomask into and out of the chamber 610.

### Examples

Example 1 may include a method. In various aspects and examples, the method may include providing a photomask, wherein the photomask may include a trench (alternatively referred to as a "channel" in the present disclosure) defined by two sidewalls which are exposed, introducing the photomask into a controlled environment, and directing (i) one or more reactive gases, (ii) a laser, (iii) one or more reactive gases and a laser, or (iv) one or more reactive gases and an electron beam, to at least one of the sidewalls (e.g., the two sidewalls) to render a passivation layer adjacent to and in contact with each sidewall. In various aspects and examples, the photomask may include a substrate, and a film on and in contact with the substrate. The film may be a patterned film. The patterned film may include the trench. The trench may be defined by one or more (e.g., two) of such sidewalls and the substrate. The sidewalls, which are exposed, may face each other. The terms "trench" and "channel", in the context of the present disclosure, are exchangeable with the term "black border". More details of the black border are described in one or more examples below and in aspects of the present disclosure.

Example 2 may include the method of example 1 and/or any other example disclosed herein, wherein providing the photomask may include forming a film on and in contact with the substrate. In various aspects and examples, the film may be a patterned film. In various aspects and examples, providing the photomask may include forming the trench in the patterned film. In various aspects and examples, providing the photomask may include etching the photomask to form the trench.

Example 3 may include the method of example 1 and/or any other example disclosed herein, wherein introducing the photomask into the controlled environment may include loading the photomask on a chuck, and supplying an inert gas or generating a vacuum to render the controlled environment. In various aspects and examples, the inert gas may include argon or nitrogen.

Example 4 may include the method of example 1 and/or any other example disclosed herein, wherein directing (i) the one or more reactive gases, (ii) the laser, (iii) the one or more reactive gases and the laser, or (iv) the one or more reactive gases and the electron beam, to the two sidewalls may include dispensing a reactive species toward one of the sidewalls, and/or projecting the laser or the electron beam to one of the sidewalls. For example, in various instances, one or more reactive gases and a laser (or an electron beam) may be involved, the one or more reactive gases may be dispensed toward one of the sidewalls, and the laser (or electron beam) may be projected toward one of the sidewalls which the one or more reactive gases are dispensed toward.

Example 5 may include the method of example 4 and/or any other example disclosed herein, wherein the reactive species may include a plasma.

Example 6 may include the method of example 4 and/or any other example disclosed herein, wherein the reactive species may include oxygen, hydrogen, or a mixture of hydrogen and nitrogen. The mixture of hydrogen and nitrogen may be referred to as a "forming gas".

Example 7 may include an apparatus of the present disclosure. In various aspects and examples, the apparatus may include a chamber, a stage configured in the chamber, one or more nozzles configured in the chamber, an actuator which may be operably coupled to a respective nozzle of the one or more nozzles, and a joint which the actuator and the respective nozzle may be coupled to, wherein the respective nozzle may be rotatable by the actuator about the joint. The respective nozzle may be rotatably positioned to direct (i) the one or more reactive gases, (ii) the laser, (iii) the one or more reactive gases and the laser, or (iv) the one or more reactive gases and the electron beam, to a sidewall of a trench of a photomask placed on the stage, wherein the sidewall is exposed. In various aspects and examples, the chamber may include a door, which may be openable and closeable to allow the photomask into and out of the chamber. The actuator may be operable to have the respective nozzle that is coupled to the actuator moved from one position to another within the chamber, e.g., traversing (such as following along) a path defined by the trench.

Example 8 may include the apparatus of example 7 and/or any other example disclosed herein, wherein the stage may include a chuck.

Example 9 may include the apparatus of example 7 and/or any other example disclosed herein, wherein each of the one or more nozzles may include an outlet. In various aspects and examples, each of the one or more nozzles may be configured in the chamber to be traversable along a path defined by the trench.

Example 10 may include the apparatus of example 9 and/or any other example disclosed herein, wherein the one or more nozzles may be rotatably positioned to have the outlet face a sidewall of a photomask which may be placed on the stage in the chamber and the outlet may be positioned above the sidewall. In various aspects and examples, the one or more nozzles may be positioned in the chamber (i) to dispense a reactive species toward the sidewall and/or (ii) to project a laser or an electron beam to the sidewall.

Example 11 may include the apparatus of example 10 and/or any other example disclosed herein, wherein the one or more nozzles may be orthogonally positioned with respect to the photomask and each outlet of the one or more nozzles may be positioned directly above the sidewall. In various aspects and examples, the one or more nozzles may be vertically positioned to project the laser or the electron beam vertically (or orthogonally) toward the photomask and at the sidewall.

Example 12 may include the apparatus of example 10 and/or any other example disclosed herein, wherein the one or more nozzles may be positioned at an angle with respect to the sidewall. In various aspects and examples, the one or more nozzles may be positioned to project the laser or the electron beam at an angle with respect to the sidewall.

Example 13 may include the apparatus of example 10 and/or any other example disclosed herein, wherein the outlet may be positioned at one point above the sidewall and the one or more nozzles may be moveable by the actuator to have the outlet positioned at another point above the sidewall.

Example 14 may include a photomask of the present disclosure. The photomask may include a substrate, a patterned film on and in contact with the substrate, and an absorber on and in contact with the patterned film, wherein the patterned film may include a trench defined by two sidewalls, wherein the sidewalls may include a passivation layer adjacent to and in contact with each sidewall, and wherein the passivation layer may be formed in the absence of additional patterning processes. In other words, the passivation layer may be formed without any additional patterning process steps, such as photolithogrpahy and/or etching. In various aspects and examples, the passivation layer may have a length which may be not more than (or more than) a total height of the patterned film and the absorber. The term "trench", as mentioned above, may be referred to as "channel" or "black border". The passivated layer of the sidewall may be facing the trench.

Example 15 may include the photomask of example 14 and/or any other example disclosed herein, wherein the substrate may include a low thermal expansion material (LTEM). In the context of the present disclosure, low thermal expansion material (and understandably LTEM substrates) are materials that have a desirably low coefficient of thermal expansion (CTE), such that the LTEM helps the substrate's dimensions to remain stable over a wide temperature range, for example, during a photolithography process where temperature variations may affect pattern fidelity and during exposure to a beam, such as a hot laser beam. In other words, LTEM helps minimize the risk of defects caused by thermal distortion, meaning that a substrate formed of LTEM undergoes minimal dimensional changes in response to temperature variations. The low CTE may help in high precision applications, such as EUV and DUV lithography, where even microscopic changes in the substrate dimensions may undesirably lead to significant distortions in photomask patterns. Moreover, LTEM tends to be compatible for use with EUV and DUV due to their low absorption of EUV and DUV. Substrates composed of LTEM may be referred to in the present disclosure as LTEM substrates. LTEM substrates, i.e., the substrate, may include fused silica, or other glass-based (e.g., specialized glass) materials engineered to have reduced thermal expansion properties (i.e., low CTE) or have stability and resistance to thermal deformation.

Example 16 may include the photomask of example 15 and/or any other example disclosed herein, wherein the low thermal expansion material may include a glass-based material.

Example 17 may include the photomask of example 14 and/or any other example disclosed herein, wherein the patterned film may be multi-layered and may include one or more layers of silicon and/or molybdenum. The pattern film, as a non-limiting example, may have 40 layers. Other than silicon (Si) and molybdenum (Mo), the one or more layers may include ruthenium (Ru) and silicon (Si), zirconium (Zr) and aluminum (Al), silicon carbide (SiC) and magnesium (Mg), or chromium (Cr) and carbon (C).

Example 18 may include the photomask of example 14 and/or any other example disclosed herein, wherein the patterned film may include alternating layers of silicon and molybdenum, ruthenium and silicon, zirconium and aluminum, silicon carbide and magnesium, or chromium and carbon. The patterned film, as a non-limiting example, may have 40 layers, wherein the 40 layers may include alternating layers of silicon and molybdenum, ruthenium and silicon, zirconium and aluminum, silicon carbide and magnesium, or chromium and carbon.

Example 19 may include the photomask of example 14 and/or any other example disclosed herein, wherein the passivation layer may include a metallic passivation layer or a dielectric passivation layer. Non-limiting examples of the metallic passivation layer may include chromium nitride (CrN), tantalum nitride (TaN), nickel (Ni), and/or ruthenium (Ru). Non-limiting examples of the dielectric passivation layer may include silicon nitride (SiN) and/or silicon dioxide (SiO₂).

Example 20 may include the photomask of example 14 and/or any other example disclosed herein, wherein the passivation layer may have a length identical to a total height of the patterned film and the absorber. As mentioned above, the photomask may further include an absorber on the patterned film. The absorber may be a layer on the film (e.g., the patterned film) of a photomask. In various aspects and examples, the passivation layer may be adjacent to and in contact with the absorber (as well as the patterned film). In various aspects and examples, the part of the passivation layer that may be adjacent to and in contact with the absorber may have a length identical to or greater than the thickness (i.e., height) of the absorber. In various aspects and examples, the passivation layer may be horizontally configured on and in contact with the absorber and/or the passivation layer may be vertically configured adjacent to and in contact with the absorber. The absorber may be made of materials that have high opacity to ultraviolet light, such as EUV and/or DUV, meaning they effectively block such ultraviolet radiation. Non-limiting examples of materials usable as the absorber may include tantalum-based compounds, ruthenium nitride (RuN) or a metal (e.g., chromium or tungsten), as they may provide the optical contrast against the reflective film (e.g., the patterned film) which the absorber may be disposed directly on. In various aspects and examples, the absorber may include tantalum nitride (TaN), tantalum boron nitride (TaBN), or ruthenium nitride (RuN). Other suitable materials may be used as the absorber.

The term "comprising" shall be understood to have a broad meaning similar to the term "including" and will be understood to imply the inclusion of a stated integer or operation or group of integers or operations but not the exclusion of any other integer or operation or group of integers or operations. This definition also applies to variations on the term "comprising" such as "comprise" and "comprises".

While the present disclosure has been particularly shown and described with reference to specific aspects, it should be understood by persons skilled in the art that various changes in form and detail may be made therein without departing from the scope of the present disclosure as defined by the appended claims. The scope of the present disclosure is thus indicated by the appended claims and all changes which come within the meaning and range of equivalency of the claims are therefore intended to be embraced.

## Claims

1. A method comprising:
providing a photomask, wherein the photomask comprises a trench defined by two sidewalls which are exposed;
introducing the photomask into a controlled environment; and
directing (i) one or more reactive gases, (ii) a laser, (iii) one or more reactive gases and a laser, or (iv) one or more reactive gases and an electron beam, to the two sidewalls to render a passivation layer adjacent to and in contact with each sidewall.

2. The method of claim 1, wherein providing the photomask comprises forming a patterned film on and in contact with a substrate.

3. The method of any one of claims 1 or 2, wherein introducing the photomask into the controlled environment comprises:
loading the photomask on a chuck; and
supplying an inert gas or generating a vacuum to render the controlled environment.

4. The method of any one of claims 1 to 3, wherein directing (i) the one or more reactive gases, (ii) the laser, (iii) the one or more reactive gases and the laser, or (iv) the one or more reactive gases and the electron beam, to the two sidewalls comprises:
dispensing a reactive species toward one of the sidewalls; and/or
projecting a laser or an electron beam to one of the sidewalls.

5. The method of claim 4, wherein the reactive species comprises a plasma.

6. The method of any one of claims 4 or 5, wherein the reactive species comprises oxygen, hydrogen, or a mixture of hydrogen and nitrogen.

7. An apparatus comprising:
a chamber;
a stage configured in the chamber;
one or more nozzles configured in the chamber;
an actuator which is operably coupled to a respective nozzle of the one or more nozzles; and
a joint which the actuator and the respective nozzle are coupled to, wherein the respective nozzle is rotatable by the actuator about the joint.

8. The apparatus of claim 7, wherein the stage comprises a chuck.

9. The apparatus of any one of claims 7 or 8, wherein each of the one or more nozzles comprises an outlet.

10. The apparatus of claim 9, wherein the one or more nozzles are rotatably positioned to have the outlet face a sidewall of a photomask which is placed on the stage in the chamber and the outlet is positioned above the sidewall.

11. The apparatus of claim 10, wherein the one or more nozzles are orthogonally positioned with respect to the photomask and each outlet of the one or more nozzles is positioned directly above the sidewall.

12. The apparatus of any one of claims 10 or 11, wherein the one or more nozzles are positioned at an angle with respect to the sidewall.

13. The apparatus of any one of claims 10 to 12, wherein the outlet is positioned at one point above the sidewall and the one or more nozzles are moveable by the actuator to have the outlet positioned at another point above the sidewall.
